# EUROPEAN PATENT APPLICATION

(11) **EP 4 844 531 A1**
(43) Date of publication of application: **25.11.2026**
(21) Application number: 26178865.7
(22) Date of filing: 15.05.2026
(51) Int. Cl.: G06F 1/16, H10K 59/80

(54) **DISPLAY MODULE AND ELECTRONIC DEVICE INCLUDING THE SAME**

(30) Priority: 22.05.2025 KR 20250066860
(71) Applicant: Samsung Display Co., Ltd., Yongin-si, Gyeonggi-do 17113 (KR)
(72) Inventor: JEONG, Gyeongho, Giheung-gu, Yongin-si, Gyeonggi-do (KR); SHIN, Jaiku, Giheung-gu, Yongin-si, Gyeonggi-do (KR); PARK, Sungjune, Giheung-gu, Yongin-si, Gyeonggi-do (KR)
(74) Representative: Dr. Weitzel & Partner

(57) **Abstract**

A display module includes a display panel, an intermediate adhesive layer, a support plate, a lower adhesive layer, a cover member, a release film layer, a heat dissipation member and a support member. The intermediate adhesive layer is below the display panel and includes first and second intermediate adhesive members spaced apart from each other. The support plate has folding opening parts defined therein which are not overlapping with the first or second intermediate adhesive members. The support plate is below the intermediate adhesive layer. The lower adhesive layer is below the support plate and includes first and second lower adhesive members spaced apart from each other. The cover member is between the first and second lower adhesive layer and overlaps the folding opening parts.

## Description

The present invention relates to a display module and an electronic device including the same, with improved display quality.

An electronic device includes a display module, and the display module includes a plurality of elements and an adhesive member to attach the elements to each other. The adhesive member may be perceptible to a user, and display quality of the display module may be degraded accordingly. Therefore, in order to improve display quality of the display module, it is important to design a display module such that the above-described adhesive member is not perceptible.

An object of the present invention is to provide a display module having a structure in which the above-described adhesive member is not perceptible to a user, and an electronic device including the same.

The invention is defined by the features of the independent claims. The dependent claims and the description provide preferred embodiments.

A display module according to an embodiment of the present invention includes a display panel, an intermediate adhesive layer, a support plate, a lower adhesive layer, a cover member, a release film layer, a heat dissipation member, and a support member.

The intermediate adhesive layer includes a first intermediate adhesive member and a second intermediate adhesive member spaced apart from each other. The intermediate adhesive layer is positioned below the display panel. The support plate has a plurality of folding opening parts not overlapping with the first intermediate adhesive member and the second intermediate adhesive member. That means, the plurality of folding opening parts is outside of the first intermediate adhesive member and the second intermediate adhesive member in a planar view onto the upper side or lower side of the display module. The support plate is positioned below the intermediate adhesive layer. The lower adhesive layer includes a first lower adhesive member and a second lower adhesive member spaced apart from each other. The lower adhesive layer is positioned below the support plate. The cover member overlaps with the plurality of folding opening parts. The cover member is positioned between the first lower adhesive member and the second lower adhesive member. The release film layer includes a first film member, a second film member, and a third film member. The first film member is positioned between the first lower adhesive member and the cover member and makes contact with the support plate. The second film member is positioned between the second lower adhesive member and the cover member and makes contact with the support plate. The third film member extends from the first film member to the second film member. The heat dissipation member overlaps with any one of the first lower adhesive member and the second lower adhesive member. The support member overlaps with the other of the first lower adhesive member and the second lower adhesive member. The support member includes a material different from that of the heat dissipation member.

In an embodiment of the present invention, at least a portion of the first intermediate adhesive member may overlap with the third film member in a planar view.

In an embodiment of the present invention, the third film member may be spaced apart from the cover member.

In an embodiment of the present invention, the second film member may be spaced apart from the first film member in a predetermined direction. A length of the at least a portion of the first intermediate adhesive member measured in the predetermined direction may be greater than or equal to about 1 millimeter (mm) and less than or equal to about 2 millimeters (mm). A spaced distance between the third film member and the cover member may be greater than or equal to about 0.005 mm and less than or equal to about 0.01 mm.

In an embodiment of the present invention, the second film member may be spaced apart from the first film member in a predetermined direction. A spaced distance between the third film member and the cover member may be greater than or equal to about 0.1% and less than or equal to about 2.0% of the length of the at least a portion of the first intermediate adhesive member measured in a predetermined direction.

In an embodiment of the present invention, the release film layer may further include a fourth film member and a fifth film member. The fourth film member may extend from the first film member. The fourth film member may make contact with the heat dissipation member. The fifth film member may extend from the second film member. The fifth film member may make contact with the support member.

In an embodiment of the present invention, the first film member may include an upper surface, a lower surface, and a side surface. The upper surface may make contact with the support plate. The lower surface may face the upper surface. The side surface may extend from the upper surface to the lower surface. The upper surface may have a smaller area than the lower surface.

In an embodiment of the present invention, the side surface may have a predetermined curvature.

In an embodiment of the present invention, one side of the fourth film member may make contact with the heat dissipation member. Another side of the fourth film member may face the one side of the fourth film member. One side of the fifth film member may make contact with the support member. Another side of the fifth film member may face the one side of the film member. The release film layer may further include a sixth film member extending from the other side of the fourth film member or the other side of the fifth film member.

In an embodiment of the present invention, a thermal conductivity of the heat dissipation member may be greater than a thermal conductivity of the support member. A stiffness of the support member may be greater than a stiffness of the heat dissipation member.

A display module according to an embodiment of the present invention includes a release film layer, a cover member, a heat dissipation member, a support member, a lower adhesive member, a support plate, an intermediate adhesive member, and a display panel. The release film layer includes a first film member, a second film member, and a third film member. The second film member is spaced apart from the first film member. The third film member extends from the first film member to the second film member. The cover member is spaced apart from the third film member. The heat dissipation member is at the side of any one of the first film member and the second film member. The support member is at the side of the other of the first film member and the second film member. The support member includes a material different from that of the heat dissipation member. The lower adhesive member is positioned above the heat dissipation member. The support plate has a plurality of folding opening parts defined therein, the plurality of folding opening parts overlapping with the cover member. The support plate is positioned above the cover member. The support plate makes contact with the first film member and the second film member. The intermediate adhesive member does not overlap with the plurality of folding opening parts. The intermediate adhesive member is positioned above the support plate. The display panel is positioned above the intermediate adhesive member.

In an embodiment of the present invention, at least a portion of the intermediate adhesive member may overlap with the third film member in a planar view.

In an embodiment of the present invention, the second film member may be spaced apart from the first film member in a predetermined direction. A length of the at least a portion of the first intermediate adhesive member measured in the predetermined direction may be greater than or equal to about 1 mm and less than or equal to about 2 mm. A spaced distance between the third film member and the cover member may be greater than or equal to about 0.005 mm and less than or equal to about 0.01 mm.

In an embodiment of the present invention, the second film member may be spaced apart from the first film member in a predetermined direction. A spaced distance between the third film member and the cover member may be greater than or equal to about 0.1% and less than or equal to about 2.0% of the length of the at least a portion of the intermediate adhesive member measured in a predetermined direction.

In an embodiment of the present invention, the release film layer may further include a fourth film member and a fifth film member. The fourth film member may extend from the first film member. The fourth film member may make contact with the heat dissipation member. The fifth film member may extend from the second film member. The fifth film member may make contact with the support member.

In an embodiment of the present invention, the first film member may include an upper surface, a lower surface, and a side surface. The upper surface may make contact with the support plate. The lower surface may face the upper surface. The side surface may extend from the upper surface to the lower surface. The upper surface may have a smaller area than the lower surface.

In an embodiment of the present invention, the side surface may have a predetermined curvature.

A display module according to an embodiment of the present invention includes a display panel, an intermediate adhesive layer, a support plate, a lower adhesive layer, a cover member, a heat dissipation member, a support member, a first dummy member, and a second dummy member. The intermediate adhesive layer includes a first intermediate adhesive member and a second intermediate adhesive member spaced apart from each other. The intermediate adhesive layer is positioned below the display panel. The support plate has a plurality of folding opening parts defined therein, the plurality of folding opening parts not overlapping with the first intermediate adhesive member and the second intermediate adhesive member. The support plate is positioned below the intermediate adhesive layer. The lower adhesive layer includes a first lower adhesive member and a second lower adhesive member spaced apart from each other. The lower adhesive layer is positioned below the support plate. The cover member overlaps with the plurality of folding opening parts. The cover member is positioned between the first lower adhesive member and the second lower adhesive member. The heat dissipation member overlaps with any one of the first lower adhesive member and the second lower adhesive member. The support member overlaps with the other of the first lower adhesive member and the second lower adhesive member. The support member includes a material different from that of the heat dissipation member. The first dummy member includes a release agent. The first dummy member makes contact with the support plate between the first lower adhesive member and the cover member. The second dummy member includes a release agent. The second dummy member makes contact with the support plate between the cover member and the second lower adhesive member.

In an embodiment of the present invention, a first portion of the support plate may overlap with the first dummy member. A second portion of the support plate may overlap with the second dummy member. A third portion of the support plate may extend from the first portion of the plate to the second portion of the support plate. At least a portion of the first intermediate adhesive member may overlap with the third portion of the support plate in a planar view.

In an embodiment of the present invention, the second portion of the support plate may be spaced apart from the first portion of the support plate in a predetermined direction. A length of the at least a portion of the first intermediate adhesive member measured in the predetermined direction may be greater than or equal to about 1 mm and less than or equal to about 2 mm.

A display module in an embodiment of the present invention may further include a third dummy member and a fourth dummy member. The third dummy member may include a release agent. The third dummy member may make contact with the heat dissipation member. The fourth dummy member may include a release agent. The fourth dummy member may make contact with the support member.

An electronic device according to the present invention includes a display module, a processor, a memory, and a power module. The display module is configured to emit light. The processor is configured to control the display module .The memory is configured to store data necessary for operation of the display module or the processor. The power module is configured to generate or supply power.

According to an embodiment of the present invention, the present invention may provide a display module having a structure in which the described adhesive member is not perceptible to a user, and an electronic device including the same.

The accompanying drawings are included to provide a further understanding of the present invention and are incorporated in and constitute a part of this invention. The drawings illustrate embodiments of the present invention and, together with the description, serve to explain principles of the invention. These and/or other features will become apparent and more readily appreciated from the following description of one or more embodiments, taken in conjunction with the accompanying drawings, in which:
FIG. 1A is an illustration in which an electronic device according to an embodiment of the present invention is in an unfolded state;
FIG. 1B is an illustration of an electronic device according to an embodiment of the present invention in a folded state;
FIG. 2 is an exploded view of a display module of the electronic device shown in FIG. 1A;
FIG. 3 is a plan view of a display module of the electronic device shown in FIG. 1A;
FIG. 4A and FIG. 4B are cross-sectional views of a display module and a display panel, respectively, according to an embodiment of the present invention, taken along the line I-I' line shown in FIG. 1A;
FIG. 5 is an illustration of a shape of a release film layer according to an embodiment of the present invention;
FIG. 6 is an illustration of a shape of a release film layer according to an embodiment of the present invention;
FIG. 7A and FIG. 7B are illustrations of shapes of a release film layer according to embodiments of the present invention;
FIG. 8A is an exploded view of a display module of the electronic device shown in FIG. 1A;
FIG. 8B is a cross-sectional view of a display module according to an embodiment of the present invention, taken along the I-I' line shown in FIG. 1A;
FIG. 9A is a block diagram of an electronic device according to an embodiment of the present invention; and
FIG. 9B illustrates schematic views of electronic devices according to various embodiments.

References will now be made in detail to embodiments, of which examples are illustrated in the accompanying drawings, where like reference numerals refer to like elements throughout. The embodiments may have a variety of forms and permutations, but the present invention shall by no means be construed as being limited to the described embodiments. Accordingly, the embodiments are merely described below, by referring to the figures, to explain features of the present invention.

Like or identical reference numerals refer to like or identical elements. Moreover, in the accompanying drawings, the thicknesses, ratios, and dimensions of the elements may not be to exact scale and may have been exaggerated for the benefit of effective explanation of the technical features associated with these elements. As such, the present invention shall not be restricted to the thicknesses, ratios, dimensions, etc. illustrated in the drawings.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." The expression "and/or" encompasses all possible combinations of the associated elements.

An expression such as "comprising" or "including" is intended to designate a characteristic, a number, a step, an operation, an element, a part or combinations thereof, and shall not be construed to preclude any possibility of presence or addition of one or more other characteristics, numbers, steps, operations, elements, parts or combinations thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present invention, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

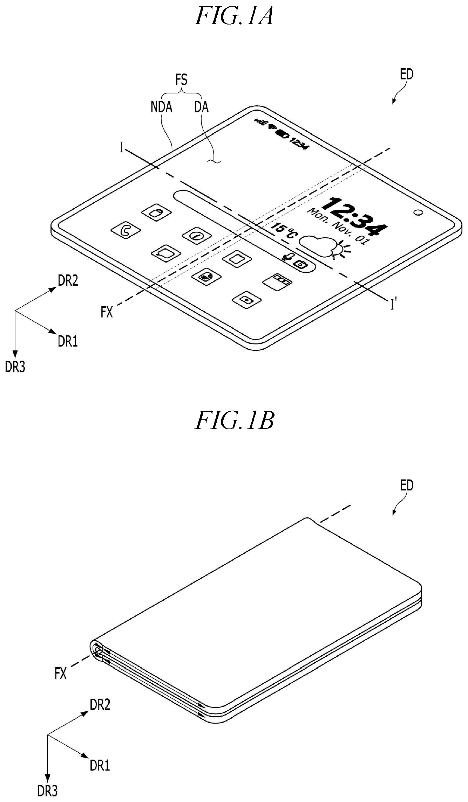

FIG. 1A is an illustration in which an electronic device ED according to an embodiment of the present invention is in an unfolded state.

FIG. 1B is an illustration of an electronic device ED according to an embodiment of the present invention in a folded state.

An electronic device ED may be a device activatable in response to an electrical signal. The electronic device ED may show an image through a display surface FS. The display surface FS may be disposed in a plane defined by a first direction DR1 and a second direction DR2 crossing each other. The display surface FS of the electronic device ED may include a display area DA and a non-display area NDA. The non-display area NDA may be adjacent to the display area DA, such as to surround the display area DA in a plan view.

The second direction DR2 may be a direction perpendicular to the first direction DR1.

The third direction DR3 may be a thickness direction of the electronic device ED and may be perpendicular to the first direction DR1 and the second direction DR2. A plan view may be defined along the thickness direction.

Referring to FIG. 1A and FIG. 1B, the electronic device ED may be foldable with respect to a folding axis FX extending in a direction parallel with the second direction DR2.

In the present invention, in-folding refers to folding of the electronic device ED such that the display surface FS is not exposed to outside, and out-folding refers to folding of the electronic device ED such that the display surface FS is exposed to outside. Although FIG. 1B illustrates that the electronic device ED is in an in-folded state, the present invention is not limited thereto. In an embodiment of the present invention, the electronic device ED may be capable of being in-folded or out-folded. In an embodiment of the present invention, the electronic device ED may be capable of both being in-folded and out-folded.

Although FIG. 1A and FIG. 1B illustrate a smartphone as the electronic device ED, the electronic device ED of the present invention is not limited thereto. In an embodiment of the present invention, the electronic device ED may include at least any one of a large-sized flexible display and a medium- to small-sized flexible display. For example, a large-sized flexible display may include a television, a monitor, and a signboard. A middle- to small-sized flexible display may include a tablet, a display embedded in home appliances, a smartwatch and a smartphone.

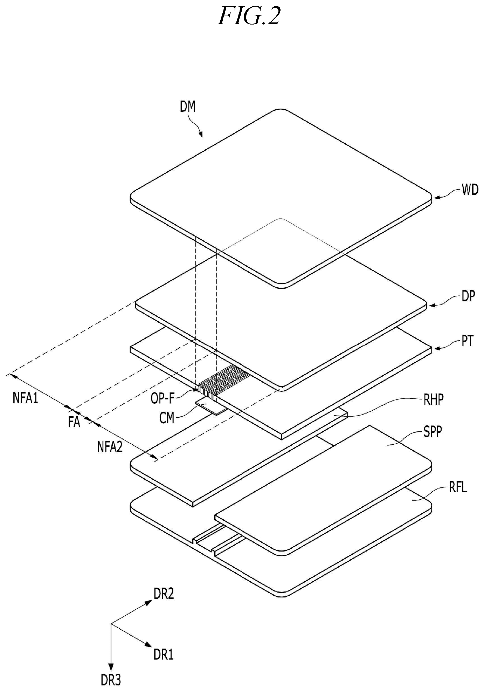

FIG. 2 is an exploded view of a display module DM of the electronic device ED shown in FIG. 1A.

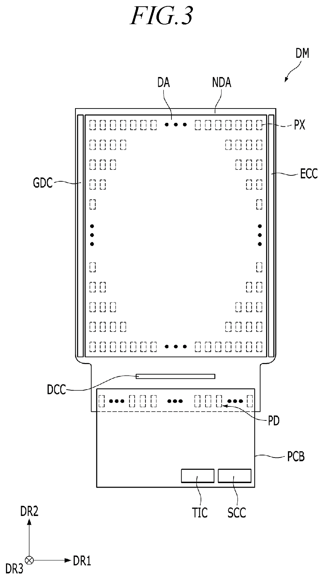

FIG. 3 is a plan view of a display module Dm of the electronic device ED shown in FIG. 1A.

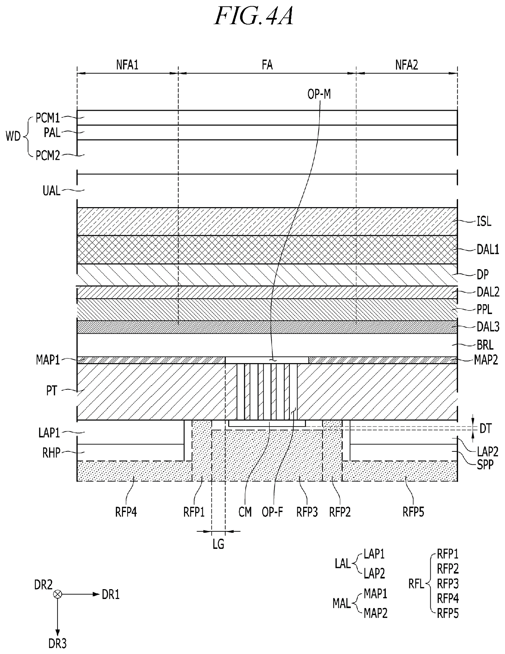

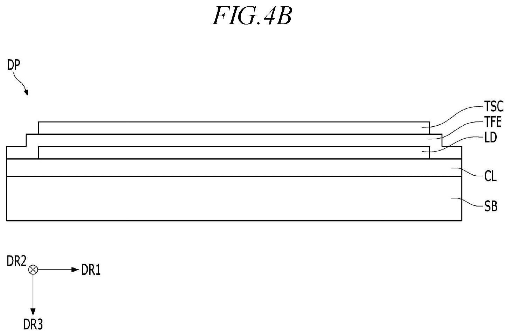

FIG. 4A and FIG. 4B are cross-sectional views of a display module DM and a display panel DP, respectively, according to an embodiment of the present invention, taken along the I-I' line shown in FIG. 1A.

Referring to FIG. 2 through FIG. 4B, the display module DM may include a window WD, an upper adhesive layer UAL, an impact absorption layer ISL, a first display unit adhesive layer DAL1, a display panel DP, a second display unit adhesive layer DAL2, a panel protection layer PPL, a third display unit adhesive layer DAL3, a barrier layer BRL, an intermediate adhesive layer MAL, a support plate PT, a cover member CM, a lower adhesive layer LAL, a heat dissipation member RHP, a support member SPP, a release film layer RFL, a gate driving circuit GDC, a light-emission control circuit ECC, a data driving circuit DCC, a printed circuit board PCB, an input sensor driving circuit TIC, a signal control circuit SCC, a pad PD provided in plural including a plurality of pads PD, and a pixel PX. Within the Figures and the text of the invention, a reference number indicating a singular form of an element may also be used to reference a plurality of the element.

Referring to FIG. 3, the gate driving circuit GDC may be configured to receive a control signal from the signal control circuit SCC to provide a gate signal to the pixel PX. The gate driving circuit GDC may be simultaneously formed (or provided) with layers or elements of the pixels such as through a thin film process. For example, the gate driving circuit GDC may be mounted in a form of oxide semiconductor thin film transistor (TFT) gate driver circuit (OSG) or in a form of amorphous silicon TFT gate driver circuit (ASG).

Referring to FIG. 3, the light-emission control circuit ECC may be configured to receive a control signal from the signal control circuit SCC to provide a light-emission control signal to the pixel PX. The light-emission control signal may be an electrical signal to control light-emission.

Referring to FIG. 3, the data driving circuit DCC may be configured to receive a control signal form the signal control circuit SCC to provide a data signal to the pixel PX.

Referring to FIG. 3, the input sensor driving circuit TIC and the signal control circuit SCC may be mounted on a circuit board like the printed circuit board PCB and configured to receive an electrical signal from the plurality of pads PD. The input sensor driving circuit TIC may be configured to process a signal corresponding to a user's touch and a signal corresponding to an input applied from outside (e.g., an external input).

The signal control circuit SCC (e.g., a timing controller) may be configured to control at least any one of an input sensor driving circuit TIC, a gate driving circuit GDC, a data driving circuit DCC, and a light-emission control circuit ECC. The signal control circuit SCC may be configured to receive image data and a control signal from an external graphic control unit (not shown). The control signal may include a vertical synchronization signal, a horizontal synchronization signal, a data enable signal, and a clock signal. The vertical synchronization signal may be a signal for distinguishment of frame periods. The horizontal synchronization signal may be a signal for distinguishing horizontal periods (e.g., row distinguishment signal).

Although FIG. 3 illustrates that the gate driving circuit GDC and the light-emission control circuit ECC are separate elements and are disposed to be spaced apart from each other, the gate driving circuit GDC and the light-emission control circuit ECC of the present invention are not limited thereto. For example, the gate driving circuit GDC and the light-emission control circuit ECC may be provided as a single element.

The pixel PX may be provided in a plurality, such as a plurality of pixels.

Referring to FIG. 4A, the window WD may be positioned above the display panel DP to define an exterior of the electronic device ED and protect the display panel DP. The window WD may include a flexible material. Therefore, when the electronic device ED is folded with respect to a folding axis FX (see FIG. 1A), the window WD may also be folded together with other layers or components of the electronic device ED. The window WD may include a first protective member PCM1, a protective member adhesive layer PAL, and a second protective member PCM2.

Referring to FIG. 4A, the first protective member PCM1 may be positioned above the protective member adhesive layer PAL. The first protective member PCM1 may be positioned on the second protective member PCM2 to protect the second protective member PCM2 and functional layers positioned below the second protective member PCM2 from pressure applied from outside (e.g., outside of the electronic device ED), thereby preventing deformation of the display panel DP. For example, the first protective member PCM1 may include a flexible plastic material. The first protective member PCM1 may include at least any one of polyimide (PI) and polyethylene terephthalate (PET).

Referring to FIG. 4A, the protective member adhesive layer PAL may be positioned above the second protective member PCM2. The protective member adhesive layer PAL may be positioned between the first protective member PCM1 and the second protective member PCM2 to attach the second protective member PCM2 and the first protective member PCM1 to each other.

Referring to FIG. 4A, the second protective member PCM2 may be positioned above the display module DM and include a transparent material. Accordingly, light emitted from the display panel DP may transmit through the second protective member PCM2. For example, the second protective member PCM2 may include at least any one of a glass substrate and a synthetic resin film. The synthetic resin film may include at least any one of polyimide (PI) and polyethylene terephthalate (PET). In addition, the second protective member PCM2 may include an elastomer.

In an embodiment of the present invention, the second protective member PCM2 may include a plurality of synthetic resin films attached together by an adhesive agent. In an embodiment of the present invention, the second protective member PCM2 may include a glass substrate and one or more synthetic resin films attached to each other by an adhesive agent.

Referring to FIG. 4A, the upper adhesive layer UAL may attach the window WD and the impact absorption layer ISL to each other.

Referring to FIG. 4A, the display panel DP and the impact absorption layer ISL may be attached to each other by the first display unit adhesive layer DAL1. The display panel DP and the panel protective layer PPL may be attached to each other by the second display unit adhesive layer DAL2.

Referring to FIG. 4A, the intermediate adhesive layer MAL may be positioned between the display panel DP and the support plate PT. The intermediate adhesive layer MAL may have an intermediate opening part OP-M defined therein. The intermediate adhesive layer MAL may include a first intermediate adhesive member MAP1 and a second intermediate adhesive member MAP2 spaced apart from each other. A gap may be defined between the first intermediate adhesive member MAP1 and the second intermediate adhesive member MAP2 which are spaced apart from each other. The intermediate opening part OP-M may be open at both the upper and lower surfaces of the intermediate adhesive layer MAL.

Referring to FIG. 4A, each of the first intermediate adhesive member MAP1 and the second intermediate adhesive member MAP2 may not overlap with a folding opening part OP-F provide in plural to define a plurality of folding opening parts OP-F defined in the support plate PT. The first intermediate adhesive member MAP1 and the second intermediate adhesive member MAP2 may be in a same layer as each other among layers of the display module DM. As being in a same layer, elements may be formed in a same process and/or include a same material as each other, elements may be respective portions of a same material layer, elements may be on a same layer by forming an interface with a same underlying or overlying layer, elements may be coplanar with each other or be disposed in a same thickness, etc., without being limited thereto.

At least a portion of the intermediate adhesive member MAL may overlap with a third film member RFP3 in a planar view. For example, at least a portion of the first intermediate adhesive member MAP1 may overlap with the third film member RFP3 in a planar view. As being overlapping, elements may be disposed along a same line in a direction, such as along a thickness direction, a lateral direction, etc. For example, one element may be above or below another element along a thickness direction, so as to be be considered overlapping each other, without being limited thereto.

In an embodiment of the present invention, each of the upper adhesive layer UAL, the intermediate adhesive layer MAL, the lower adhesive layer LAL may include a pressure sensitive adhesive agent (PSA). That is, the upper adhesive layer UAL, the first intermediate adhesive member MAP1, the second intermediate adhesive member MAP2, a first lower adhesive member LAP1, and a second lower adhesive member LAP2 may each include a pressure sensitive adhesive agent (PSA). However, the present invention is not limited thereto, and the upper adhesive layer UAL, the first intermediate adhesive member MAP1, the second intermediate adhesive member MAP2, the first lower adhesive member LAP1, and the second lower adhesive member LAP2 may include an optically clear adhesive (OCA) or an optically clear resin (OCR).

In an embodiment of the present invention, the release film layer RFL may include a release agent. That is, a first film member RFP1, a second film member RFP2, the third film member RFP3, a fourth film member RFP4, and a fifth film member RFP5 may each include a release agent.

Referring to FIG. 4A, a first non-foldable area NFA1, a foldable area FA, and a second non-foldable area NFA2 may be defined in each of the electronic device ED and among various elements of the electronic device ED. The foldable area FA may be positioned adjacent to one or more of a non-folding area, such as between the first non-foldable area NFA1 and the second non-foldable area NFA2.

The foldable area FA may overlap with the folding axis FX shown in FIG. 1A and FIG. 1B. The foldable area FA of the electronic device ED may include a flexible material. Therefore, when the electronic device ED is folded with respect to the folding axis FX, the foldable area FA may be folded together with other components of the electronic device ED.

Referring to FIG. 4A, the impact absorption layer ISL may be positioned above the display panel DP. The impact absorption layer ISL may absorb impact transferred from above to protect the display panel DP. The impact absorption layer ISL may include a flexible plastic material. For example, the impact absorption layer ISL may include a synthetic resin film. The synthetic resin film may include at least any one of polyimide (PI), polycarbonate, polyamide, triacetylcellulose, and polyethylene terephthalate (PET).

Referring to FIG. 4A, the first display unit adhesive layer DAL1 may be positioned between the impact absorption layer ISL and the display panel DP to attach the impact absorption layer ISL and the display panel DP to each other.

The display panel DP may be configured to emit light. The display panel DP may be positioned above the intermediate adhesive layer MAL. The display panel DP may include a plurality of pixels, and each of the plurality of pixels may include a pixel circuit configured to control a light-emitting diode and a current (e.g., electrical current) value flow through the light-emitting diode. For example, the display panel DP may be any one of an organic light-emitting display panel, a quantum dot light-emitting display panel, a micro-light emitting diode (LED) display panel, a liquid crystal display panel, an electrophoretic display panel, and an electrowetting display panel. A light-emission layer of the organic light-emitting display panel may include an organic light-emitting material. The inorganic light-emitting display panel may include a quantum dot light-emitting display panel and a micro-LED display panel based on an inorganic material.

In an embodiment of the present invention, the display panel DP may have a first non-foldable area NFA1, a foldable area FA, and a second non-foldable area NFA2 defined therein. The foldable area FA may be positioned between the first non-foldable area NFA1 and the second non-foldable area NFA2. The plurality of folding opening parts OP-F of the support plate PT may overlap with the foldable area FA.

Referring to FIG. 4A, the second display unit adhesive layer DAL2 may be positioned between the display panel DP and the panel protective layer PPL to attach the display panel DP and the panel protective layer PPL to each other.

Referring to FIG. 4A, the panel protective layer PPL may be positioned below the display panel DP. The panel protective layer PPL may be configured to absorb impact transferred from below to protect the display panel DP. The panel protective layer PPL may include a flexible plastic material. For example, the panel protective layer PPL may include polyethylene terephthalate (PET).

Referring to FIG. 4A, the third display unit adhesive layer DAL3 may be positioned between the panel protective layer PPL and the barrier layer BRL to attach the panel protective layer PPL and the barrier layer BRL to each other.

Referring to FIG. 4A, the barrier layer BRL may be positioned between the panel protective layer PPL and the intermediate adhesive layer MAL. The barrier layer BRL may prevent deformation of the display panel DP due to pressing. For example, the barrier layer BRL may include at least any one of polyimide (PI) and polyethylene terephthalate (PET).

Referring to FIG. 4A, the support plate PT may be positioned between the display panel DP and the cover member CM. Particularly, the support plate PT may be positioned below the intermediate adhesive layer MAL.

Referring to FIG. 4A, the support plate PT may be positioned below the display panel DP to support the display panel DP. The support plate PT may make contact with the first film member RFP1 between the cover member CM and the first lower adhesive member LAP1. As being in contact, elements may form an interface therebetween. The support plate PT may include an insulating material or a non-metallic material. For example, the support plate PT may include carbon fiber reinforced plastic (CFRP) or glass fiber reinforced plastic (GFRP).

Referring to FIG. 4A, the support plate PT may have a plurality of folding opening parts OP-F defined therein, the plurality of folding opening parts OP-F overlapping with the cover member CM and the intermediate opening part OP-M. The folding opening parts OP-F as support plate openings (or folding openings) may be open at upper and lower surfaces of the support plate PT, without being limited thereto. One of more of the folding opening parts OP-F may be connected to the intermediate opening part OP-M, such as to define a continuous open space, without being limited thereto

The plurality of folding opening parts OP-F may not overlap with the first intermediate adhesive member MAP1 and the second intermediate adhesive member MAP2. The plurality of folding opening parts OP-F may be arranged to have a lattice form in a planar view. One or more of the folding opening parts OP-F may have a discrete shape or an enclosed shape in the planar (or plan) view. The foldable area FA may have enhanced flexibility due to the plurality of folding opening parts OP-F. In addition, the plurality of folding opening parts OP-F may overlap with the foldable area FA in the third direction DR3.

Referring to FIG. 4A, the cover member CM may be positioned below the support plate PT and may overlap with the plurality of folding opening parts OP-F. The cover member CM may prevent introduction of a foreign substance to the display panel DP through the plurality of folding opening parts OP-F.

In an embodiment of the present invention, the cover member CM may be positioned between the first lower adhesive member LAP1 and the second lower adhesive member LAP2. In an embodiment of the present invention, the cover member CM may be positioned between the first film member RFP1 and the second film member RFP2. The cover member CM is coplanar with each of the first lower adhesive member LAP1, the second lower adhesive member LAP2, the first film member RFP1 and the second film member RFP2.

Referring to FIG. 4A, the lower adhesive layer LAL may be positioned below the support plate PT. The lower adhesive layer LAL may be positioned above the heat dissipation member RHP and the support member SPP. The lower adhesive layer LAL may include the first lower adhesive member LAP1 and the second lower adhesive member LAP2 spaced apart from each other. A gap may be defined between the first lower adhesive member LAP1 and the second lower adhesive member LAP2.

The first lower adhesive member LAP1 may overlap with any one of the heat dissipation member RHP and the support member SPP, and the second lower adhesive member LAP2 may overlap with the other of the heat dissipation member RHP and the support member SPP.

Referring to FIG. 4A, the heat dissipation member RHP may be positioned above the release film layer RFL. For example, the heat dissipation member RHP may overlap with any one of the first lower adhesive member LAP1 and the second lower adhesive member LAP2. The heat dissipation member RHP may release heat generated from the display module DM to outside. The heat dissipation member RHP may include at least any one of copper (Cu) and aluminum (Al). However, a heat dissipation member RHP of the present invention is not limited thereto.

Referring to FIG. 4A, the support member SPP may be positioned above the release film layer RFL. Particularly, the support member SPP may overlap with the other of the first lower adhesive member LAP1 and the second lower adhesive member LAP2. The support member SPP may include stainless steel. The support member SPP may be positioned below the second lower adhesive member LAP2. The support member SPP may include a material different from that of the heat dissipation member RHP.

In an embodiment of the present invention, a thermal conductivity of the heat dissipation member RHP may be greater than a thermal conductivity of the support member SPP. A stiffness of the support member SPP may be greater than a stiffness of the heat dissipation member RHP.

Referring to FIG. 4A, the release film layer RFL may include the first film member RFP1, the second film member RFP2, the third film member RFP3, the fourth film member RFP4, and the fifth film member RFP5. In an embodiment of the present invention, at least any one of the first film member RFP1, the second film member RFP2, the third film member RFP3, the fourth film member RFP4, and the fifth film member RFP5 may not be provided.

The first film member RFP1 may make contact with the support plate PT at a location between the cover member CM and the first lower adhesive member LAP1. The first film member RFP1 may make contact with the heat dissipation member RHP or the first film member RFP1 may be spaced apart from the heat dissipation member RHP in a direction along the support plate PT.

The second film member RFP2 may make contact with the support plate PT at a location between the cover member CM and the second lower adhesive member LAP2. The second film member RFP2 may make contact with the support member SPP or the second film member RFP2 may be spaced apart from the support member SPP in a direction along the support plate PT.

The third film member RFP3 may extend from the first film member RFP1 to the second film member RFP2. The third film member RFP3 may be spaced apart from the cover member CM.

In case that the intermediate adhesive layer MAL is perceptible to a user, quality of an image provided by the display module DM may be degraded.

In an embodiment of the present invention, the second film member RFP2 may be spaced apart from the first film member RFP1 in the first direction DR1. A length LG of at least a portion of the first intermediate adhesive member MAP1, which overlaps with the third film member RPF3 in a planar view, measured in the first direction DR1 may be greater than or equal to about 1 millimeter (mm) and less than or equal to about 2 millimeters (mm). A spaced distance DT from the third film member RFP3 to the cover member CM may be greater than or equal to than about 0.005 mm and less than or equal to about 0.01 mm. Here, the intermediate adhesive layer MAL may prevent degradation of image quality due to perceptibility from outside of the electronic device ED, such as to a user.

In an embodiment, the length LG may correspond to a length portion of the third film member RFP3 which is measured in a direction along the release film layer RFL and overlaps an inner end portion of the intermediate adhesive layer MAL. That is, an upper surface of the third film member RFP3 may include the length portion (e.g., corresponding to the length LG) greater than or equal to about 1 mm and less than or equal to about 2 mm, together with being spaced apart from the cover member CM by the spaced distance DT.

In an embodiment of the present invention, the second film member RFP2 may be spaced apart from the first film member RFP1 in the first direction DR1. A spaced distance DT from the third film member RFP3 to the cover member CM may be greater than or equal to about 0.1 percent (%) and less than or equal to about 2.0% of the length LG of the at least a portion of the first intermediate adhesive member MAP1 measured in the first direction DR1. In this case, the intermediate adhesive layer MAL may prevent degradation of image quality due to perceptibility to a user.

The fourth film member RFP4 may extend from the first film member RFP1. The fourth film member RFP4 may make contact with the heat dissipation member RHP.

The fifth film member RFP5 may extend from the second film member RFP2. The fifth film member RFP5 may make contact with the support member SPP.

One or more film member of the release film layer RFL may form a step or a recess. For example, the cover member CM may be disposed in a recess of the release film layer RFL which is formed by the first film member RFP1, the second film member RFP2 and the third film member RFP3. The first film member RFP1 and the fourth film member RFP4 may form a step.

Referring to FIG. 4B, the display panel DP may include a base layer SB, a circuit layer CL, a light-emitting diode layer LD, an encapsulation layer TFE, and a touch sensor circuit TSC.

Referring to FIG. 4B, the base layer SB may provide a foundation on which the circuit layer CL is positioned. The base layer SB may have a flexible property capable of, for example, bending, folding, or rolling. In an embodiment of the present invention, the base layer SB may be, for example, a glass substrate, a metal substrate, or a polymer substrate.

Referring to FIG. 4B, the base layer SB may be formed of polyethersulphone (PES), polyacrylate (PA), polyarylate (PAR), polyetherimide (PEI), polyethylene naphthalate (PEN), polyethylene Terephthalate (PET), polyphenylene sulfide (PPS), polyallylate, polycarbonate (PC), cellulosetriacetate (CAT), cellulose acetate propionate (CAP), or a combination thereof. However, the present invention is not limited thereto.

Referring to FIG. 4B, the circuit layer CL may be positioned on the base layer SB. The circuit layer CL may include, for example, a conductive pattern (not shown), a semiconductor pattern (not shown), a plurality of insulating layers (not shown), and a signal line (not shown). The circuit layer CL may include components of a pixel circuit.

Referring to FIG. 4B, the light-emitting diode layer LD as a light-emitting element layer may be positioned on the circuit layer CL. The light-emitting diode layer LD may include electrodes (not shown), functional layers (not shown), and a light-emitting diode (not shown). The light-emitting diode may include an organic light-emitting material, an inorganic light-emitting material, an organic-inorganic light-emitting material, a quantum dot, a quantum rod, a micro-LED, or a nano-LED. The light-emitting element layer may be connected (e.g., electrically connected) to the circuit layer CL.

Referring to FIG. 4B, the encapsulation layer TFE may be positioned on the light-emitting diode layer LD. The encapsulation layer TFE may protect the light-emitting diode layer LD from a foreign substance, such as moisture, oxygen, and dust particle. The encapsulation layer TFE may include an inorganic layer and an organic layer. For example, the encapsulation layer TFE may have a structure with sequential lamination of a first inorganic layer (not shown), an organic layer (not shown), and a second inorganic layer (not shown).

Referring to FIG. 4B, the touch sensor circuit TSC may be positioned on the encapsulation layer TFE. The touch sensor circuit TSC may be driven (electrically) by a capacitive method or a resistive method. The touch sensor circuit TSC may be configured to detect a portion or a magnitude of an external input such as a user's touch. The touch sensor circuit TSC may include sensor electrodes electrically insulated from each other, routing wires connected to corresponding sensing electrodes, and at least one sensor insulating layer.

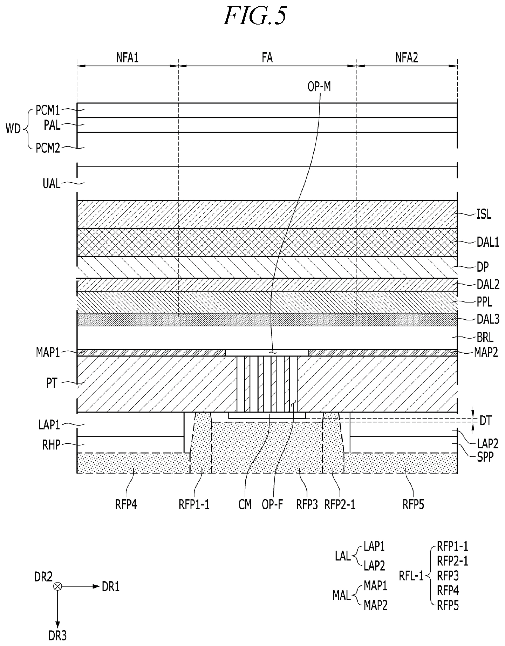

FIG. 5 is an illustration of a shape of a release film layer RFL-1 according to an embodiment of the present invention.

Referring to FIG. 5, in an embodiment of the present invention, each of the first film member RFP1-1 and the second film member RFP2-1 may include an upper surface, a lower surface, and a side surface. The upper surface may make contact with the support plate PT. That is, the upper surface may be a surface making contact with the support plate PT. The lower surface may face the upper surface. The side surface may extend from the upper surface to the lower surface. An outer side surface may include an inclined portion extended from the upper surface. The inclined portion may meet a lower portion of the outer side surface. The inclined portion may be extended from the support plate PT at a different angle than an inner side surface and the lower portion of outer side surface.

The upper surface may have a smaller area than the lower surface, in a planar view. That is, each of the first film member RFP1-1 and the second film member RFP2-1 may have a trapezoidal cross-section. In case that the first film member RFP1-1 has a trapezoidal cross-section, an area (e.g., a planar area) at which the first film member RFP1-1 makes contact with the support plate PT may be reduced, and the release film layer RFL-1 may be readily detached.

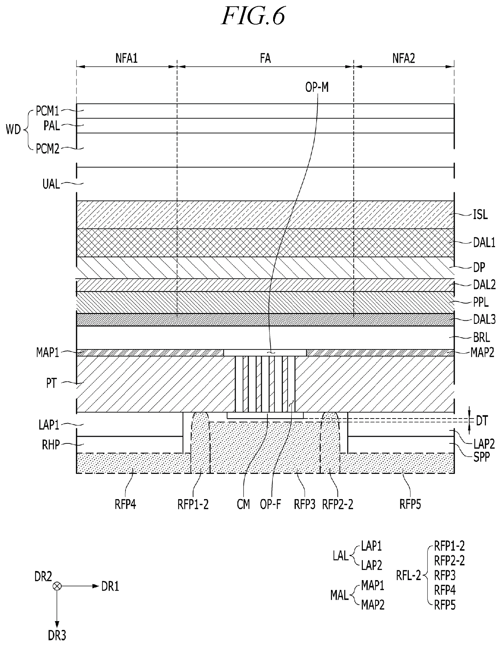

FIG. 6 is an illustration of a shape of a release film layer RFL-2 according to an embodiment of the present invention.

Referring to FIG. 6, in an embodiment of the present invention, each of the first film member RFP1-2 and the second film member RFP2-2 may include an upper surface, a lower surface, and a side surface. The upper surface may make contact with the support plate PT. That is, the upper surface may be a surface making contact with the support plate PT. The lower surface may face the upper surface. The side surface may extend from the upper surface to the lower surface.

The side surface may have a predetermined curvature at an upper portion of both an inner side surface and an outer side surface opposing each other. In case that the side surface has a predetermined curvature, an area at which the first film member RFP1-2 makes contact with the support plate PT may become reduced, and the release film layer RFL-2 may be readily detached from the support plate PT.

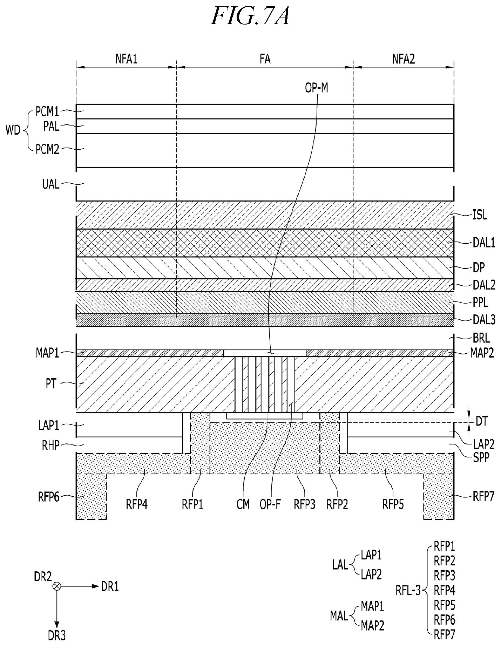

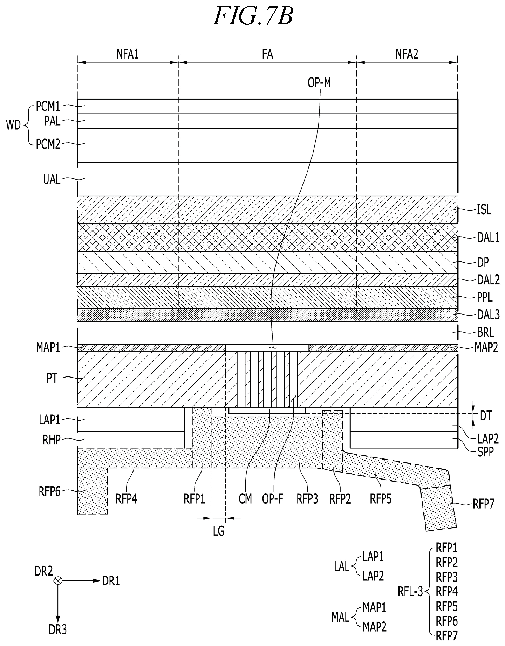

FIG. 7A and FIG. 7B are illustrations of shapes of a release film layer RFL-3 according to an embodiment of the present invention.

In an embodiment of the present invention, the release film layer RFL-3 may further include at least any one of a sixth film member RFP6 and a seventh film member RFP7.

One side (e.g., an upper surface) of the fourth film member RFP4 may make contact with the heat dissipation member RHP.

Another side (e.g., a lower surface) of the fourth film member RFP4 may face the one side of the fourth film member RFP4.

One side (e.g., an upper surface) of the fifth film member RFP5 may make contact with the support member SPP.

Another side (e.g., a lower surface) of the fifth film member RFP5 may face the one side of the fifth film member RFP5.

Referring to FIG. 7A and FIG. 7B, the sixth film member RFP6 may extend from the other side of the fourth film member RFP4 in the third direction DR3. Accordingly, by using the sixth film member RFP6, the release film layer RFL-3 may be readily detached from other layers of the electronic device ED.

Referring to FIG. 7A and FIG. 7B, the seventh film member RFP7 may extend from the other side of the fifth film member RFP5 in the third direction DR3. Accordingly, by using the seventh film member RFP7, the release film layer RFL-3 may be readily detached from other layers of the electronic device ED. For example, FIG. 7B shows detachment of the release film layer RFL-3 at the fifth film member RFP5 from a lower surface of the support member SPP. The seventh film member RFP7 may be a protrusion or protruded portion at which a force may be applied to move one or more film of the release film layer RFL-3 in a direction away from another layer so as to detach a respective release film from the another layer.

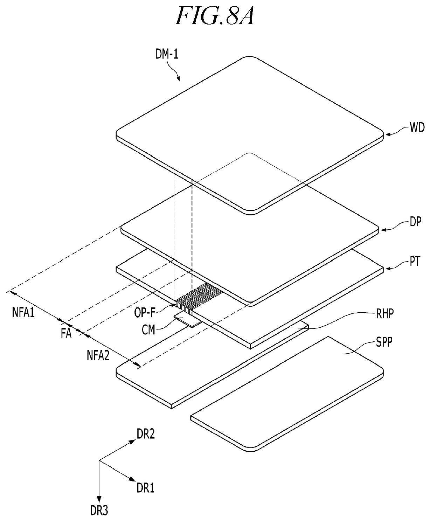

FIG. 8A is an exploded view of a display module DM-1 of the electronic device ED shown in FIG. 1A.

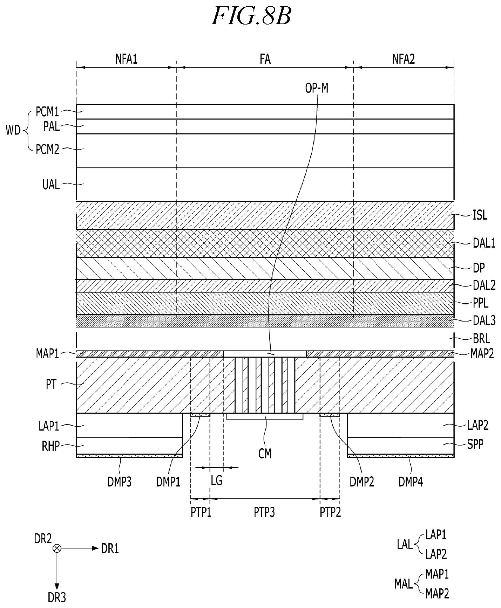

FIG. 8B is a cross-sectional view of a display module DM-1 according to an embodiment of the present invention taken along the I-I' line shown in FIG. 1A.

Referring to FIG. 8A, the display module DM-1 may be a display module DM with the release film layer RFL detached from the display module DM shown in FIG. 2. The display module DM-1 may include a display panel DP, an intermediate adhesive layer MAL, a support plate PT, a lower adhesive layer LAL, a cover member CM, a heat dissipation member RHP, a support member SPP, a first dummy member DMP1, and a second dummy member DMP2. That is, the release film layer RFL is detachably disposed at one or more layers, one or more locations, etc. along the electronic device ED.

The intermediate adhesive layer MAL may include a first intermediate adhesive member MAP1 and a second intermediate adhesive member MAP2 spaced apart from each other. The intermediate adhesive layer MAL may be positioned below the display panel DP.

The support plate PT may have a plurality of folding opening parts OP-F defined therein, the plurality of folding opening parts OP-F not overlapping with the first intermediate adhesive member MAP1 and the second intermediate adhesive member MAP2. The support plate PT may be positioned below the intermediate adhesive layer MAL.

The lower adhesive layer LAL may include a first lower adhesive member LAP1 and a second lower adhesive member LAP2 spaced apart from each other. The lower adhesive layer LAL may be positioned below the support plate PT.

The cover member CM may overlap with the plurality of folding opening parts OP-F. The cover member Cm may be positioned between the first lower adhesive member LAP1 and the second lower adhesive member LAP2.

The heat dissipation member RHP may overlap with any one of the first lower adhesive member LAP1 and the second lower adhesive member LAP2.

The support member SPP may overlap with the other of the first lower adhesive member LAP1 and the second lower adhesive member LAP2. The support member SPP may include a material different from that of the heat dissipation member RHP.

The first dummy member DMP1 may be a residue remaining after detachment of the release film layer RFL (see FIG. 4A). The first dummy member DMP1 may include a release agent. The first dummy member DMP1 may make contact with the support plate PT between the first lower adhesive member LAP1 and the cover member CM.

The second dummy member DMP2 may be a residue remaining after detachment of the release film layer RFL (see FIG. 4A). The second dummy member DMP2 may include a release agent. The second dummy member DMP2 may make contact with the support plate PT between the cover member CM and the second lower adhesive member LAP2.

In an embodiment of the present invention, a first portion PTP1 of the support plate PT may overlap with the first dummy member DMP1. A second portion PTP2 of the support plate PT may overlap with the second dummy member DMP2. A third portion PTP3 of the support plate PT may extend from the first portion PTP1 of the support plate PT to the second portion PTP2 of the support plate PT. At least a portion of the first intermediate adhesive member MAP1 may overlap with the third portion PTP3 of the support plate PT in a planar view.

In an embodiment of the present invention, the second portion PTP2 of the support plate PT may be spaced apart from the first portion PTP1 of the support plate PT in the first direction DR1. A length LG of at least a portion of the first intermediate adhesive member MAP1 measured in the first direction DR1 may be greater than or equal to about 1 mm and less than or equal to about 2 mm. In this case, the intermediate adhesive layer MAL may prevent degradation of image quality due to perceptibility to a user.

In an embodiment of the present invention, the display module DM-1 may further include a third dummy member DMP3 and a fourth dummy member DMP4.

The third dummy member DMP3 may be a residue remaining after detachment of the release film layer RFL (see FIG. 4A). The third dummy member DMP3 may include a release agent. The third dummy member DMP3 may make contact with the heat dissipation member RHP.

The fourth dummy member DMP4 may be a residue remaining after detachment of the release film layer RFL (see FIG. 4A). The fourth dummy member DMP4 may include a release agent. The fourth dummy member DMP4 may make contact with the support member SPP.

Each of the dummy members may be a remaining portion of the release film layer RFL. The dummy members may be disconnected from each other in a direction along the support plate PT. Portions of the release film layer RFL may remain on the electronic device ED or may be removed to provide the electronic device ED. The first dummy member DMP1 may have a first release agent, the second dummy member DMP2 may have a second release agent, the third dummy member DMP3 may have a third release agent and the fourth dummy member DMP4 may have a fourth release agent. That is, the dummy members may include the same release agent since each of these members are a portion of the same release film layer RFL. That is, the dummy members may be portions of a same material layer (e.g., the release film layer RFL), even though they are not coplanar with each other within the electronic device ED.

Other descriptions of the display module DM-1 are substantially same as those described with references to FIG. 4A through FIG. 7B, and thus are omitted.

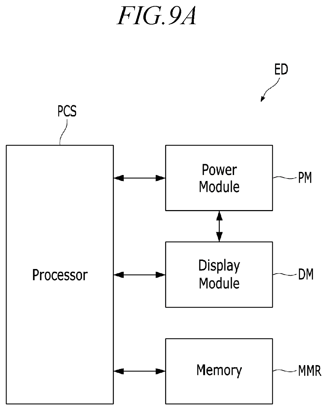

FIG. 9A is a block diagram of an electronic device ED according to an embodiment.

Referring to FIG. 9A, an electronic device ED according to an embodiment may include a display module DM, a processor PCS, a memory MMR, and a power module PM.

The processor PCS may include at least one of a central processing unit (CPU), an application processor (AP), a graphic processing unit (GPU), a communication processor (CP), an image signal processor (ISP), and a controller.

The memory MMR may be configured to store data information necessary for operation of the processor PCS or the display module DM. When the processor PCS executes an application stored in the memory MMR, an image data signal and/or an input control signal may be transferred to the display module DM, which may then process the received signals and output image information through a display screen.

The power module PM may include a power supply module, such as a power adapter or a battery device, and a power conversion module configured to convert the power supplied by the power supply module into power required for the operation of the electronic device ED.

At least one of the above-described components of the electronic device ED may be included within the display module DM according to the above-described embodiments. Additionally, individual modules included functionally within a single module may be provided within the display module DM while other individual modules may be provided outside the display module DM. For instance, the processor PCS, memory MMR, and power module PM may be provided as other devices within the electronic device ED but not within the display module DM.

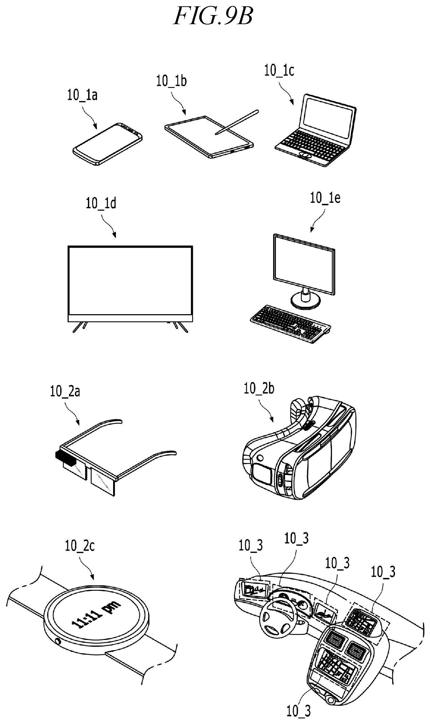

FIG. 9B illustrates schematic views of electronic devices ED according to various embodiments.

Referring to FIG. 9b, various electronic devices applied with a display module DM according to the embodiments may include not only an electronic device for displaying an image, such as a smartphone (10_1a), a tablet personal computer (PC) (10_1b), a laptop (10_1c), a television (TV) (10_1d), and a desk monitor (10_1e), but also a wearable electronic device including a display module DM, such as a smart glasses (10_2a), a head-mounted display (10_2b), and a smartwatch (10_2c), and an electronic device for a vehicle 10_3 including a display module, such as a dashboard of an automobile, a center fascia, CID (Center Information Display) disposed on a dashboard, and a room mirror display.

While embodiments of the present invention have been described above, anyone ordinarily skilled in the art to which the present invention pertains shall appreciate that there may be a variety of modifications and permutations of the present invention without departing from the technical ideas and scopes of the present invention that are defined in the appended claims. Moreover, it shall be appreciated that the disclosed embodiments are not intended to restrict the present invention.

## Claims

**1.** A display module (DM), comprising:
a display panel (DP);
an intermediate adhesive layer (MAL) comprising a first intermediate adhesive member (MAP1) and a second intermediate adhesive member (MAP2) spaced apart from each other, the intermediate adhesive layer (MAL) positioned below the display panel (DP);
a support plate (PT) having folding opening parts (OP-F) defined therein, the support plate (PT) positioned below the intermediate adhesive layer (MAL), and the folding opening parts (OP-F) not overlapping with the first intermediate adhesive member (MAP1) or the second intermediate adhesive member (MAP2);
a lower adhesive layer (LAL) comprising a first lower adhesive member (LAP1) and a second lower adhesive member (LAP2) spaced apart from each other, the lower adhesive layer (LAL) positioned below the support plate (PT);
a cover member (CM) overlapping with the folding opening parts (OP-F), the cover member (CM) positioned between the first lower adhesive member (LAP1) and the second lower adhesive member (LAP2);
a release film layer (RFL) comprising:
a first film member (RFP1) positioned between the first lower adhesive member (LAP1) and the cover member (CM) and making contact with the support plate (PT),
a second film member (RFP2) positioned between the second lower adhesive member (LAP2) and the cover member (CM) and making contact with the support plate (PT), and
a third film member (RFP3) extending from the first film member (RFP1) to the second film member (RFP2);
a heat dissipation member (RHP) overlapping with any one of the first lower adhesive member (LAP1) and the second lower adhesive member (LAP2); and
a support member (SPP) overlapping with the other of the first lower adhesive member (LAP1) and the second lower adhesive member (LAP2), the support member (SPP) comprising a material different from that of the heat dissipation member (RHP).

**2.** The display module (DM) of claim 1,
wherein the third film member (RFP3) is spaced apart from the cover member (CM).

**3.** A display module (DM), comprising:
a release film layer (RFL) comprising a first film member (RFP1), a second film member (RFP2) spaced apart from the first film member (RFP1), and a third film member (RFP3) extending from the first film member (RFP1) to the second film member (RFP2);
a cover member (CM) spaced apart from the third film member (RFP3);
a heat dissipation member (RHP) at the side of any one of the first film member (RFP1) and the second film member (RFP2);
a support member (SPP) at the side of the other of the first film member (RFP1) and the second film member (RFP2), the support member (SPP) comprising a material different from that of the heat dissipation member (RHP);
a first lower adhesive member (LAP1) positioned above the heat dissipation member (RHP);
a support plate (PT) having folding opening parts (OP-F) defined therein, the support plate (PT) positioned above the cover member (CM) and making contact with the first film member (RFP1) and the second film member (RFP2), and the folding opening parts (OP-F) overlapping with the cover member (CM);
a first intermediate adhesive member (MAP1) positioned above the support plate (PT) and not overlapping with the folding opening parts (OP-F); and
a display panel (DP) positioned above the first intermediate adhesive member (MAP1).

**4.** The display module (DM) of at least one of claims 1 to 3,
wherein at least a portion of the first intermediate adhesive member (MAP1) overlaps with the third film member (RFP3) in a planar view.

**5.** The display module (DM) of claim 4,
wherein the second film member (RFP2) is spaced apart from the first film member (RFP1) in a direction (DR1) along the support plate (PT),
wherein a length (LG) of the at least a portion of the first intermediate adhesive member (MAP1) in the direction (DR1) along the support plate (PT) is greater than or equal to about 1 millimeter and less than or equal to about 2 millimeters, and
wherein a spaced distance (DT) between the third film member (RFP3) and the cover member (CM) is greater than or equal to about 0.005 millimeter and less than or equal to about 0.01 millimeter.

**6.** The display module (DM) of claims 4 or 5,
wherein the second film member (RFP2) is spaced apart from the first film member (RFP1) in a direction (DR1) along the support plate (PT),
a length (LG) of the at least a portion of the first intermediate adhesive member (MAP1) is defined in the direction (DR1) along the support plate (PT), and
wherein a spaced distance (DT) between the third film member (RFP3) and the cover member (CM) is greater than or equal to about 0.1% and less than or equal to about 2.0% of the length (LG) of the at least a portion of the first intermediate adhesive member (MAP1).

**7.** The display module (DM) of at least one of claims 1 to 6,
wherein the release film layer (RFL) further comprises:
a fourth film member (RFP4) extending from the first film member (RFP1), the fourth film member (RFP4) making contact with the heat dissipation member (RHP); and
a fifth film member (RFP5) extending from the second film member (RFP2), the fifth film member (RFP5) making contact with the support member (SPP).

**8.** The display module (DM) of at least one of claims 1 to 7,
wherein the first film member (RFP1) comprises:
an upper surface making contact with the support plate (PT);
a lower surface facing the upper surface; and
a side surface extending from the upper surface to the lower surface,
and
wherein the upper surface has a smaller area than the lower surface.

**9.** The display module (DM) of claim 8,
wherein the side surface has a curvature.

**10.** The display module (DM) of at least one of claims 6,
wherein one side of the fourth film member (RFP4) makes contact with the heat dissipation member (RHP),
wherein another side of the fourth film member (RFP4) faces the one side of the fourth film member (RFP4),
wherein one side of the fifth film member (RFP5) makes contact with the support member (SPP),
wherein another side of the fifth film member (RFP5) faces the one side of the fifth film member (RFP5), and
wherein the release film layer (RFL) further comprises a sixth film member (RFP6) extending from the other side of the fourth film member (RFP4) or the other side of the fifth film member (RFP5).

**10.** The display module (DM) of claim 4,
wherein a thermal conductivity of the heat dissipation member (RHP) is greater than a thermal conductivity of the support member (SPP), and
wherein a stiffness of the support member (SPP) is greater than a stiffness of the heat dissipation member (RHP).

**11.** A display module (DM), comprising:
a display panel (DP);
an intermediate adhesive layer (MAL) comprising a first intermediate adhesive member (MAP1) and a second intermediate adhesive member (MAP2) spaced apart from each other, the intermediate adhesive layer (MAL) positioned below the display panel (DP);
a support plate (PT) having folding opening parts (OP-F) defined therein, the support plate (PT) positioned below the intermediate adhesive layer (MAL), and the folding opening parts (OP-F) not overlapping with the first intermediate adhesive member (MAP1) or the second intermediate adhesive member (MAP2);
a lower adhesive layer (LAL) comprising a first lower adhesive member (LAP1) and a second lower adhesive member (LAP2) spaced apart from each other, the lower adhesive layer (LAL) positioned below the support plate (PT);
a cover member (CM) overlapping with the folding opening parts (OP-F), the cover member (CM) positioned between the first lower adhesive member (LAP1) and the second lower adhesive member (LAP2);
a heat dissipation member (RHP) overlapping with any one of the first lower adhesive member (LAP1) and the second lower adhesive member (LAP2);
a support member (SPP) overlapping with the other of the first lower adhesive member (LAP1) and the second lower adhesive member (LAP2), the support member (SPP) comprising a material different from that of the heat dissipation member (RHP); and
dummy members (DMP) positioned below the support plate (PT) and each comprising a release agent, the dummy members (DMP) comprising:
a first dummy member (DMP1) making contact with a portion of the support plate (PT) which is between the first lower adhesive member (LAP1) and the cover member (CM); and
a second dummy member (DMP2) making contact with a portion of the support plate (PT) which is between the cover member (CM) and the second lower adhesive member (LAP2).

**12.** The display module (DM) of claim 11,
wherein a first portion (PTP1) of the support plate (PT) overlaps with the first dummy member (DMP1),
wherein a second portion (PTP2) of the support plate (PT) overlaps with the second dummy member (DMP2),
wherein a third portion (PTP3) of the support plate (PT) extends from the first portion (PTP1) of the plate to the second portion (PTP2) of the support plate (PT), and
wherein at least a portion of the first intermediate adhesive member (MAP1) overlaps with the third portion (PTP3) of the support plate (PT) in a planar view.

**13.** The display module (DM) of claim 12,
wherein the second portion (PTP2) of the support plate (PT) is spaced apart from the first portion (PTP1) of the support plate (PT) in a direction (DR1) along the support plate (PT), and
wherein a length (LG) of the at least a portion of the first intermediate adhesive member (MAP1) in the direction (DR1) along the support plate (PT) is greater than or equal to about 1 millimeter and less than or equal to about 2 millimeters.

**14.** The display module (DM) of at least one of claims 11 to 13,
wherein the dummy members (DMP) further comprise:
a third dummy member (DMP3) making contact with the heat dissipation member (RHP); and
a fourth dummy member (DMP4) making contact with the support member (SPP).

**15.** An electronic device (ED), comprising:
a display module (DM) according to at least one of claims 1 to 14 configured to emit light;
a processor (PCS) configured to control the display module (DM);
a memory (MMR) configured to store data necessary for operation of the display module (DM) or the processor (PCS); and
a power module (PM) configured to generate or supply power.
